Europäisches Patentamt

European Patent Office

Office européen des brevets

(11) Publication number: **0 032 014**
**B1**

(12) EUROPEAN PATENT SPECIFICATION

(45) Date of publication of patent specification: **08.07.87**

(21) Application number: **80304529.3**

(22) Date of filing: **16.12.80**

(51) Int. Cl.$^4$: **G 11 C 11/24**, G 11 C 11/34, G 11 C 11/40

(54) Semiconductor memory circuit.

(30) Priority: **27.12.79 JP 169187/79**

(43) Date of publication of application:
**15.07.81 Bulletin 81/28**

(45) Publication of the grant of the patent:
**08.07.87 Bulletin 87/28**

(84) Designated Contracting States:
**DE FR GB**

(56) References cited:
**EP-A-0 029 099**
**DE-A-2 853 204**
**US-A-3 848 237**

(73) Proprietor: **FUJITSU LIMITED**
**1015, Kamikodanaka Nakahara-ku**
**Kawasaki-shi Kanagawa 211 (JP)**

(72) Inventor: **Shimada, Hiroshi**
**33-3, Kitashinjuku 4-chome Shinjuku-ku**
**Tokyo. 160 (JP)**
Inventor: **Aoyama,Keizo**
**1-11-28, Tsukimino**
**Yamato-shi Kanagawa 242 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to a semiconductor memory circuit, and more particularly to a static type semiconductor memory circuit.

A semiconductor memory circuit, for example, a static type semiconductor memory circuit basically comprises many memory cells, for storing data, arranged in a matrix, word decoders for specifying the address of memory cells in the matrix from the word direction and column decoders for specifying the address of memory cells from the colomn direction. These word decoders and column decoders are respectively arranged along one side of the memory cell matrix in a vertical direction and along one side of the memory cell matrix in a lateral direction, and can enable the data stored in one memory cell, specified in both vertical and lateral directions, to be read. In reality, the memory cells are divided into two groups:— a right memory cell group and a left memory cell group, and word decoders are arranged centrally between the right and left memory cell groups (see e.g. DE—A—2853204). This is because if the word decoders were arranged in the vertical direction on one side of the memory cell matrix a voltage drop between one end and the other of polysilicon electrodes extending in the lateral direction across the matrix from the decoders would be of considerable size. Therefore, the word decoders are located centrally between the right and left memory cell groups in order to reduce a voltage drop along such an electrode by half, and to share equally the voltage drop between the right and left memory cell groups, thereby improving memory functions.

However, a semiconductor memory circuit as mentioned above has inevitable disadvantages. the first disadvantage is high power consumption, and the second disadvantage is that output operation speed cannot be made very high even at the expense of such disadvantageous high power consumption. This latter disadvantage arises as follows. Namely, bit current flows to all memory cells storing data "L" (low level data) among memory cells associated with one selected word decoder, as a result of the structure of the semiconductor memory circuit, without regard to whether or not the relevant memory cells are also selected in the bit direction. Therefore, if that bit current, which is mostly unwanted and used in vain, can be at least reduced by half, this would be a measure going a considerable way towards removing such disadvantage above.

US—A—3 848 237 discloses a dynamic memory with X-decoders between left and right dynamic cell arrays. Lines extending from these decoders include left and right side switches, and there are provided left and right drivers for controlling those switches.

According to the present invention there is provided a semiconductor memory circuit of static type having a plurality of word lines each extending through right and left memory cell groups and corresponding respectively to respective rows of the memory cell groups, and having word decoders, corresponding to respective word lines, located between the right and left memory cell groups, each memory cell having a pair of transfer transistors having gates connected to one of the word lines, characterised in that the semiconductor memory circuit further comprises a respective right memory cell group selection and drive gate and a respective left memory cell group selection and drive gate provided for each word decoder and including discriminating means, for discriminating to which of the right and left memory cell groups a memory cell to be accessed belongs, and providing a discrimination result, either the right or the left memory cell group selection and drive gate being closed in dependence upon the discrimination result, and each memory call group selection and drive gate further including a clamping means, connected respectively between a voltage source and the right and left memory cell groups, for clamping the corresponding word line on the side of the closed gate.

An embodiment of the present invention can provide a semiconductor memory circuit which can provide for a reduced bit current and thereby reduced power consumption.

An embodiment of the present invention can provide a semiconductor memory circuit which can reduce power consumption by means of a simple additional construction. Further, an embodiment of the present invention can provide a semiconductor memory circuit which can provide for speed up of output operation.

An embodiment of the present invention provides discrimination means which discriminate to which of right and left memory cell groups a specified memory cell belongs, right and left memory cell group drive gates provided for each word decoder, one or other of the right and left memory cell group drive gates being closed in accordance with the result of discrimination of the discrimination means.

Reference is made, by way of example, to the accompanying drawings, in which:—

Figure 1 is a schematic circuit diagram for assistance in explanation of the structure and operation of a general semiconductor memory circuit;

Figure 2 is a schematic circuit diagram illustrating an embodiment of the present invention; and

Figure 3 is a schematic diagram illustrating arrangement patterns of word decoders and memory cell groups different from that of Figure 2 to which embodiments of the present invention can also be applied.

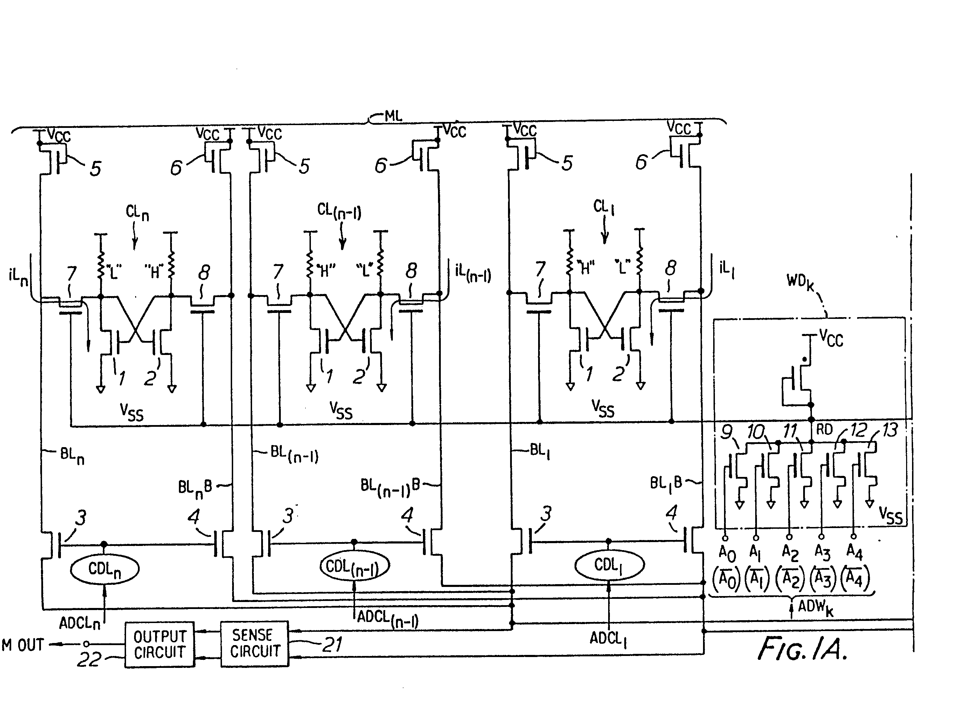

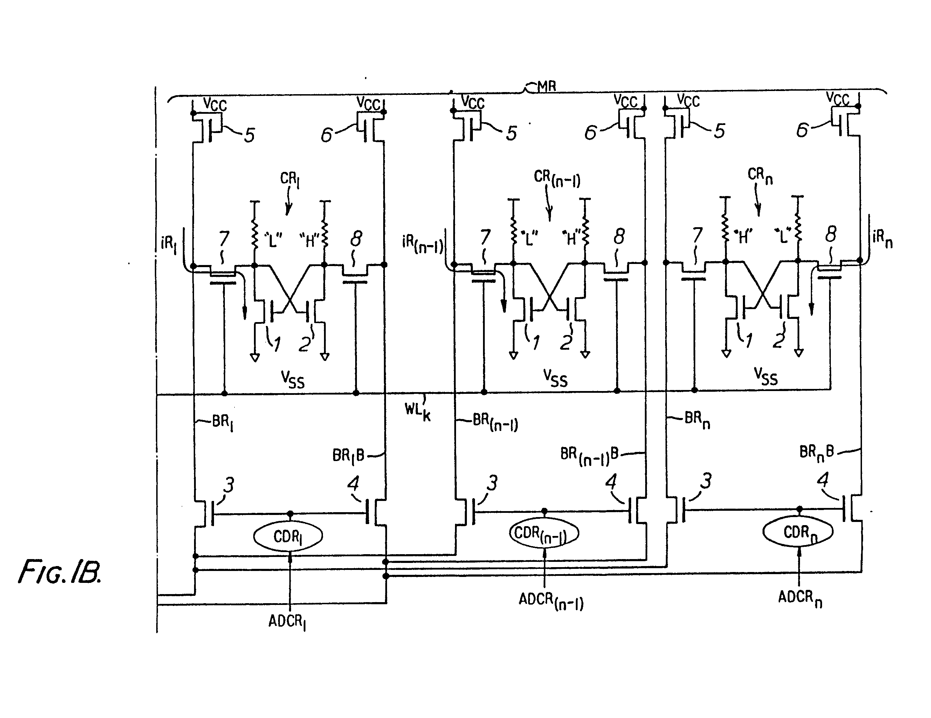

In Figure 1, ML is a left memory cell group and MR is a right memory cell group, and word decoders are provided between the memory cell groups in correspondence to cell rows. However, in Figure 1, only word decoder WDk of the kth row is indicated. The word decoder WDk drives in common all the bits on the word line WLk.

Considering the left memory cell group ML, $n$ memory cells CL1 to CLn are connected along the word line WLk and each of those memory cells comprises a pair of FETs (1, 2) which operate in the complementary mode and a pair of transfer FETs (7, 8). To the pairs of FETs (1, 2) of the memory cells respective bit line pairs (BL1, BL1B) to (BLn, BLnB) are connected. The bit lines BL1, BL1B) to (BLn, BLnB) respectively output complementary logical bit data. The complementary bits of this bit data on respective bit line pairs are led to respective pairs of FETs (3, 4) connected to respective column decoders CDL1 to CDLn, and input to a sense circuit 21 after being wire ORed for all FETs (3, 4) associated with all column decoders CDL1 to CDLn, and output as a memory output Mout via an output circuit 22. The FETs (5, 6) inserted in each of the bit lines BL1B, BL1...BLnB, BLn are load FETs.

The abovementioned structure is also adopted for the right memory cell group MR, where CDR1 to CDRn are column decoders, BR1, BR1B...BRn, BRnB are bit lines, CR1 to CRn are memory cells.

If an address is specified for memory cell CL1 (the memory cell connected to the first bit lines (BL1, BL1B) within the left memory cell group ML), the word decoder WDk connected to that memory cell CL1 is selected from among the word decoders by a word address ADWk.

The word address ADWk consists of address bits A0 (or $\overline{A0}$), A1 (or $\overline{A1}$), A2 (or $\overline{A2}$), A3 (or $\overline{A3}$), and A4 (or $\overline{A4}$) when the number of memory cells in the column direction is 32.

When the word decoder WDk is specified by the word address ADWk, all FETs (9, 10, 11, 12, and 13) constituting word decoder WDk become OFF and therefore word line WDk becomes of "H" (high) level so that the transfer FETs (7, 8) of the corresponding memory cells become ON. Thereby, bit currents iL1 to iLn and iR1 to iRn flow to each FET (7 or 8) on the side of that FET (1 or 2) storing data "L" in each pair of FETs (1, 2) of the memory cells CL1 to CLn and CR1 to CRn on the word line WLk, from power supply Vcc to power supply Vss. Then, the column decoder CDL1 corresponding to the relevant memory cell CL1 from among all the column decoders (CDL1 to CDLn and CDR1 to CDRn) is designated by a column address ADCL1, and the data stored in the memory cell CL1 is output through the sense circuit 21 and output circuit 22 via the bit lines (BL1, BL1B). The Column address ADCL, consists of address bits A5 (or $\overline{A5}$), A6 (or $\overline{A6}$), A7 (or $\overline{A7}$) A8 (or $\overline{A8}$) and A9 (or $\overline{A9}$) when the number of memory cells in the word direction is 32.

Focusing attention on the bit currents, even when an address is specified only for memory cell CL1, unwanted and useless bit currents also flow into all memory cells other than the memory cell CL1.

The total (unwanted) bit current becomes very heavy and is as high as indicated by the following equation.

$$\sum_{r=1}^{n} iLr + \sum_{r=1}^{n} iRr - iL1$$

This means that power consumption becomes high and a high speed operation is considerably restricted because all memory cells must be driven at one time.

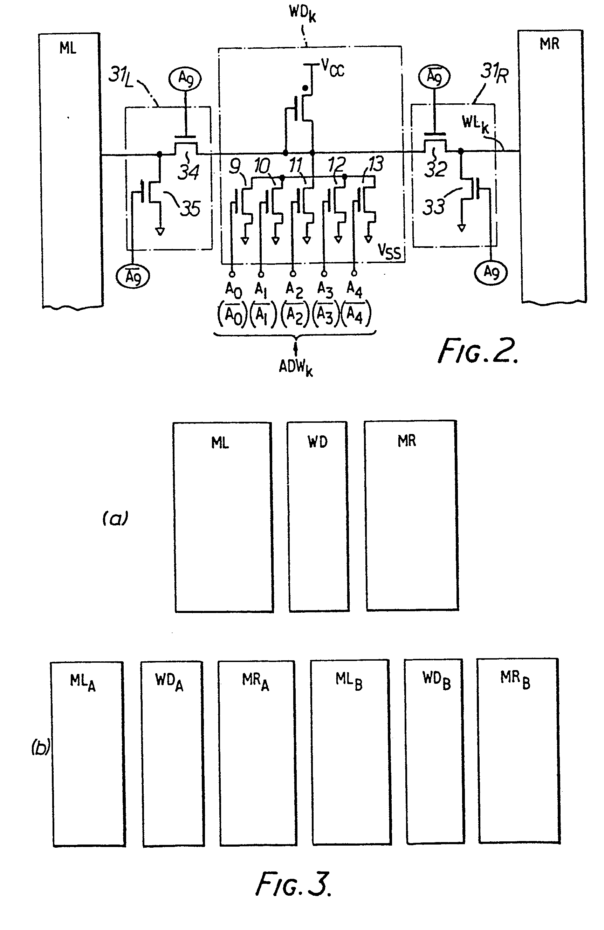

In an embodiment of the present invention, some additional circuits are connected to each word decoder with a view to reducing the total amount of the bit current by half. Figure 2 shows an embodiment of the present invention. In this Figure, a left memory cell group (ML) drive gate 31L and a right memory cell group (MR) drive gate 31R are provided on the left and right sides of each word decoder, and these left and right memory cell group drive gates 31R and 31L are closed alternatively.

The gates 31L and 31R receive respectively the lowest (last) column address bit A9 and its complementary bit $\overline{A9}$, for example, which discriminates whether a memory cell specified for access is of the left or the right memory cell group (MR, ML). Since memory cell CL1 of the left memory cell group ML is designated, the address bit A9 is logic "1" i.e. "H" level. Thus, the left memory cell group drive gate 31L opens and simultaneously the right memory cell group drive gate 31R closes. Thus the right side of the word line WLk is not driven and the current indicated by

$$\sum_{r=1}^{n} iRr$$

in the total bit current above becomes zero. On the other hand, if a memory cell in the right memory cell group MR is accessed, the address bit A9 is logic "0" i.e. "L" level and the right memory cell group drive gate 31R opens and simultaneously the left memory cell group drive gate 31L closes. Therefore, the left part of the word line WLk is not driven and the current indicated by

$$\sum_{r=1}^{n} iLr$$

in the total bit current becomes zero. Power consumption is substantially halved.

The right and left memory cell group drive gates 31R and 31L respectively comprise transistors (32, 33) and transistors (34, 35). The transistor 32 and transistor 34 are inserted in series in the word line WDk but transistor 33 and transistor 35 are connected in parallel between wird line WDk and power supply Vss. In principle, the desired gate function can be obtained by transistor 32 and transistor 34 alone, but it is desirable to keep the corresponding right or left word line forcibly to a specified potential (Vss) by means of transistor 33 or 35 which becomes ON simultaneously with the transistors 34 or 32 when they become ON, in order to prevent that right or left word line floating (i.e. for clamping), which floating could result in erroneous operation when the transistor 32 or 34 becomes OFF. Namely, the transistors 32 and 33 are ON or OFF complementarily and the transistors 34 and 35 also are ON or OFF complementarily.

In addition, transistors 32 and 34 must become ON or OFF alternatively and therefore they require the discrimination results A9 and $\overline{A9}$ as input signals. According to the example above, in a case in which the memory cell CL1 is specified, the transistor 34 becomes ON because A9="H" and the transistor 35 becomes OFF because $\overline{A9}$="L". On the other hand, the transistor 32 becomes OFF because $\overline{A9}$="L" and the transistor 33 becomes ON because A9="H". In this case, the memory cells in the right side can be put into the not-driven condition without being placed in a floating mode.

Figure 3 shows examples or arrangement patterns of word decoders and memory cell groups to which the present invention can be applied.

In Figure 3, (a) shows an arrangement pattern corresponding to Figure 1.

In Figure 3, (b) shows an arrangement pattern in which two word decoders ($WD_A$, $WD_B$) are provided between a first right memory cell group $MR_A$ and a first left memory cell group $ML_A$, and a second right memory cell group $MR_B$ and a second left memory cell group $ML_B$, respectively.

As explained above, embodiments of the present invention can realise semiconductor memory circuits in which power consumption is reduced to almost one half that of a existing circuits and which are also suitable for high speed operation.

A semiconductor memory circuit embodying this invention is provided with a right memory cell group and a left memory cell group, divided to the right and left, and word decoders corresponding to respective rows of the memory cell groups which are located between the right and left memory cell groups and which specify an address in the word direction of the memory cell groups, and column decoders corresponding to respective columns and which specify an address in the bit direction of the memory cell groups. The semiconductor memory circuit comprises right and left memory cell group selection and drive gates provided for each word decoder and means for discriminating whether a memory cell to be accessed is of the right or left memory cell groups.

Thereby, the right or left memory cell group selection and drive gates are closed alternatively in accordance with the discrimination result provided by the discrimination means.

## Claims

1. A semiconductor memory circuit of static type having a plurality of word lines (WLk) each extending through right and left memory cell groups (MR, ML) and corresponding respectively to respective rows of the memory cell groups, and having word decoders (WDk), corresponding to respective word lines, located between the right and left memory cell groups, each memory cell (CLn) having a pair of transfer transistors (7, 8) having gates connected to one of the word lines, characterised in that the semiconductor memory circuit further comprises a respective right memory cell group selection and drive gate (31R) and a respective left memory cell group selection and drive gate (31L) provided for each word decoder and including discriminating means (32, 34), for discriminating to which of the right and left memory cell groups a memory cell to be accessed belongs, and providing a discrimination result, either the right or the left memory cell group selection and drive gate being closed in dependence upon the discrimination result, and each memory cell group selection and drive gate further including clamping means (33, 35) connected respectively between a voltage source and the right and left memory cell groups, for clamping the corresponding word line on the side of the closed gate.

2. A semiconductor memory circuit as claimed in claim 1, wherein the discrimination result is provided by a specified bit (A9, $\overline{A9}$) from among column address bits employed for accessing the memory cells.

3. A semiconductor memory circuit as claimed in claim 1 or 2, wherein the discrimination means of each of the right and left memory cell group selection and drive gates comprises a transistor (32, 34) connected in series to the corresponding word line.

## Patentansprüche

1. Halbleiterspeichervorrichtung vom statischen Typ mit einer Vielzahl von Wortleitungen (WL$_k$), die sich durch rechte und linke Speicherzellengruppen (MR, ML) erstrecken und jeweils entsprechenden Reihen der Speicherzellengruppen entsprechen, und mit Wortdekodern (WD$_k$), die jeweiligen Wortleitungen entsprechen, die zwischen den rechten und linken Speicherzellengruppen angeordnet sind, wobei jede Speicherzelle (CL$_n$) ein Paar von Transfertransistoren (7, 8) hat, deren Gates mit einer der Wortleitungen verbunden sind, dadurch gekennzeichnet, daß die Halbleiterspeicherschaltung ferner ein entsprechendes Gate (31R) zur Auswahl und zum Treiben der rechten Speicherzellengruppe und ein entsprechendes Gate (31L) zur Auswahl und zum Treiben der linken Speicherzellengruppe umfaßt, die für jeden Wortdekoder vorgesehen sind, und Diskriminierungseinrichtungen (32, 34) umfassen, zum Dickriminieren, zu welcher der rechten und linken Speicherzellengruppen eine Speicherzelle, zu der zugegriffen werden soll, gehört, und die ein Diskriminierungsergebnis liefern, wobei entweder das Gate zur Auswahl und zum Treiben der rechten oder der linken Speicherzellengruppe geschlossen ist, in Abhängkeit von dem Diskriminierungsergebnis, und jedes Gate zur Auswahl und zum Treiben der Speicherzellengruppe ferner eine Klemmeinrichtung (33, 35) umfaßt, die jeweils zwischen einer Spannungsquelle und der rechten bzw. der linken Speicherzellengruppe verbunden ist, um die entsprechende Wortleitung auf der Seite des geschlossenen Gates zu klemmen.

2. Halbleiterspeichervorrichtung nach Anspruch 1, bei der das Diskriminierungsergebnis durch ein spezifiziertes Bit (A9, A9) von Spaltenadressenbits geliefert wird, die zum Zugreifen zu den Speicherzellen verwendet werden.

3. Halbleiterspeicherschaltung nach Anspruch 1 oder 2, bei der die Diskriminierungseinrichtung von jedem der Gates zur Auswahl und zum Treiben der rechten und der linken Speicherzellengruppen einen Transistor (32, 34) umfaßt, der in Reihe mit der entsprechenden Wortleitung verbunden ist.

**Revendications**

1. Circuit de mémoire à semiconducteurs du type statique possédant plusieurs lignes do mot (WLk) passant chacune dans des groupes de cellules de mémoire de droite et de gauche (MR, ML) et correspondant respectivement à des rangées respectives des groupes de cellules de mémoire, et possédant des décodeurs de mot (WDk), correspendant à des lignes de mot respectives, placés entre les groupes de cellules de mémoire de droite et de gauche, chaque cellule de mémoire (CLn) possédant une paire de transistors de transfert (7, 8) dont les grilles sont connectées à l'une des lignes de mot, caractérisé en ce que le circuit de mémoire à semiconducteurs comprend en outre une porte (31R) de commande et de sélection du groupe de cellules de mémoire de droite respectif et une porte (31L) de commande et de sélection du groupe de cellules de mémoire de gauche respectif qui sont prévues pour chaque décodeur de mot et comportant an moyen de discrimination (32, 34), servant à déterminer auquel des groupes de cellules de mémoire de droite et de gauche une cellule de mémoire à laquelle il doit être accédé appartient, et à produire un résultat de discrimination, l'une des portes de commande et de sélection des groupes de cellules de mémoire de droite et de gauche étant fermée en fonction du résultat de discrimination, et chaque porte de commande et de sélection de groupe de cellules de mémoire comportant en outre un moyen de verrouillage (33, 35) respectivement connectée entre une source de tension et les groupes de cellules de mémoire de droite et de gauche, afin de verrouiller la ligne de mot correspondante se trouvant du côté de la porte fermée.

2. Circuit de mémoire à semiconducteurs selon la revendication 1, où le résultat de discrimination est formé par un bit spécifié (A9, $\overline{A9}$) appartenant aux bits d'adresse de colonne employés pour donner l'accès aux cellules de mémoire.

3. Circuit de mémoire à semiconducteurs selon la revendication 1 ou 2, où le moyen de discrimination de chacune des portes de commande et de sélection des groupes de cellules de mémoire de droite et de gauche comprend un transistor (32, 34) connecté en série à la ligne de mot correspondante.

*FIG. IA.*

Fig. IB.

FIG.2.

FIG.3.